# EUROPEAN PATENT APPLICATION

(11) **EP 2 256 810 A1**
(43) Date of publication of application: **01.12.2010**
(21) Application number: 09425213.7
(22) Date of filing: 29.05.2009
(51) Int. Cl.: H01L 27/146

(54) **Method for the production of a 3D solid-state radiation detector**

(71) Applicant: Fondazione Bruno Kessler, 38122 Trento (IT)
(72) Inventor: Boscardin, Maurizio, 38068 Rovereto (IT)
(74) Representative: Cinquantini, Bruno

(57) **Abstract**

Method for the production of a 3D detector comprising a wafer (1) and a plurality of partial incisions (5 and 6) whose perimetral walls are doped alternately and in a different way, being said perimetral walls put into contact by means of metallic contacts (7) on both larger sides (11 and 12) of the wafer (1). Said production method comprises the realization of a first and second oxide layer on both larger sides of the wafer, the insulation of the wafer by means of the doping of the interface surfaces with said oxide layers, the making of conductive areolas near said first oxide layer by means of doping and cross incision with respect to said oxide layers by passing through said second oxide layer up to said first oxide layer, said incisions intercepting said doped areolas, and then the appropriate doping of the perimetral surfaces of said incisions and the making of openings by means of oxide layers for coming into contact with the doped areolas from the outside using metallic material.

## Description

### Field of the invention

The present invention refers to a method for the production of a 3D solid-state radiation detector.

### Description of the prior art

Both planar and 3D solid-state radiation detectors are known in the art, in the field of the particle accelerators.

The use of such devices is more and more widespread in the nuclear physics domain, in particular because of the increase of the luminosity of the particle accelerators, therefore the recognition of the radiation traces has determined a remarkable development in the 3D sensor field.

In the last few years, the progress in the sensor drawing and in the construction material of the sensors themselves has definitely increased the radiation tolerance of the sensors used at present. This has allowed to use tracking systems based on silicon detectors in experiments at the Large Hadron Collider (LHC) at a nominal luminosity of 10³⁴cm⁻²s⁻¹ for about 10 years of work.

The sensors used at present, in particular the pixel detectors, are going to be replaced and the 3D detectors are likely to be used more and more.

It is worth to emphasize that 3D detectors are suitable also for other applications, for example the X-ray cristallography domain.

The 3D detectors known in the art comprise a three-dimensional matrix of electrodes of both doping types, cut out perpendicularly to the wafer surface, appropriately oxidized, and which completely penetrate through the substrate. Such incised areas may be filled with appropriately doped material or they may be used for doping the surfaces at the perimeter of the incisions. Such doped areas, moreover, are connected to metallic elements which define the clamp of the sensors.

Thus it is possible to obtain a succession of junctions in the volume of the silicon substrate.

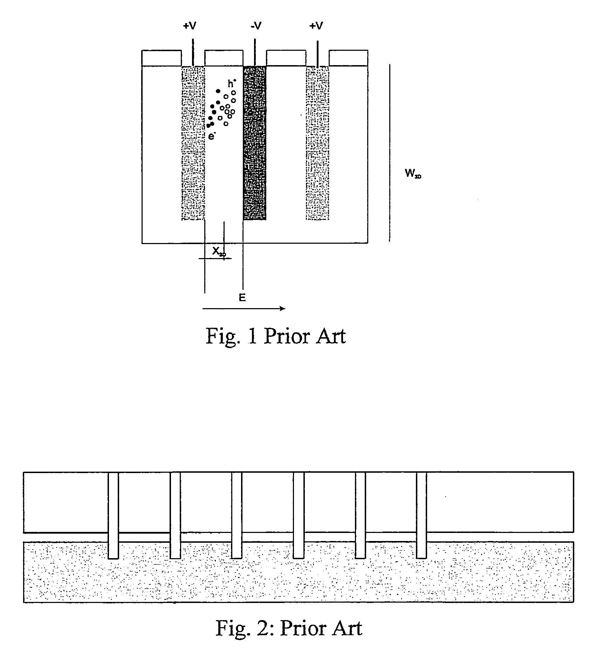

Figure 1 shows a diagram of a 3D detector known in the art.

The planar radiation detector collects the charge on the wafer surface, while in the 3D architecture there are electrodes perpendicular to the wafer surface which partially or completely penetrate through the volume of the slice. The reduced distance between the electrodes results in a substantially lower depletion tension with respect to planar detectors, which is independent from the thickness of the silicon slices used, thus determining a higher resistance to the damages caused by the radiations. Also, these sensors have a dead area which is remarkably smaller than that of the planar detectors. A further important advantage is that they have a high signal collection speed, due to the reduced distances that the carriers have to cover before being collected by the electrodes. For these reasons, the 3D sensor technology is the most suitable for satisfying the pressing requirements of the future particle accelerators, and also for being applied in other domains such as that of the radiographic imaging, where a high spatial resolution and a high signal reading speed are required also in case of very thick slices (up to 1 mm).

A technical problem connected to the production of 3D sensors derives from the difficulty to make incisions or through holes almost perfect. In the technique known in the art, a substrate slice, e.g. made of silicon, additional to that used for the detector, is attached on the slice that will constitute the detector, so that it function as a mechanical support to the slice to be worked. This technique allows the etching of the silicon for making the holes pass through both the slice being worked and, at least partially, its support substrate, as shown in figure 2 of the technique know in the art, in order to obtain perfect incisions of the slice being worked.

The drawback of this process is that, at the end of the working, said substrate has to be removed from the worked slice by means of etchings or by means of mechanical removal, with the technical difficulties connected to the fact that it is necessary to preserve the structures obtained on the worked slices.

Moreover, this technique does not allow to obtain structures on the back of the slice.

### Summary of the invention

The aim of the invention is to provide a method for manufacturing a 3D solid-state radiation detector which allows to obtain an improvement in the exploitation of the volume of the wafer and a higher manufacturing simplicity and inexpensiveness for the 3D sensor.

Therefore, the subject of the present invention is a method for manufacturing a 3D solid-state radiation detector, according to the claim 1.

According to another aspect of the invention, said device can be applied in the experiments with synchrotron light for reconstructing the ADN sequencing, or for studying the molecular characteristics or the crystallography of the proteins, or for making optical sensors and photovoltaic cells. Finally, these devices may be used as fast photo detectors, which can be applied in different domains, such as that of the short-range optical communications.

Advantageously, it is possible to produce sensors for applications where the dead areas, namely non-working areas, between the detectors are not acceptable such as in medicine, biology, high energy physics and astronomy. Having an extremely reduced dead area between the sensors allows to interpolate the signals or the non-active regions, without the need of superimposing adjacent detectors, in order to simplify the assembling system.

The dependent claims describe the preferred embodiments of the invention, and are an integral part of this description.

### Brief description of the Figures

Further characteristics and advantages of the invention will be more apparent in light of a detailed description of a preferred, but non-exclusive, embodiment of 3D solid-state radiation detector, shown with the help of the drawings that are attached hereto, which are merely illustrative and not limitative, in which:
Fig.1 schematically shows the section of a 3D solid-state sensor known in the prior art;
Fig. 2 schematically shows a section of a first silicon wafer supported by a second wafer suitable to function as a mechanical support in order to produce through holes in the first silicon wafer according to the prior art;
Fig. 3 shows the section of a oxidized silicon wafer on the larger surfaces according to the present invention;
Fig. 4 shows the making of doped areolas in a part of the wafer of figure 3;
Fig. 5 shows the adding of a further layer with respect to figure 4;
Fig. 6 shows the making of the first incisions in the wafer of figure 5, whose perimetral surface is appropriately doped;
Fig. 7 shows the junction of metallic contacts in order to come into contact with the doped areas in figure 6 from the outside;
Fig. 8 shows the invention as a whole.

In the drawings of the present invention, the same reference numbers and letters are used to identify the same elements or components of the present invention.

### Detailed description of a preferred embodiment of the invention

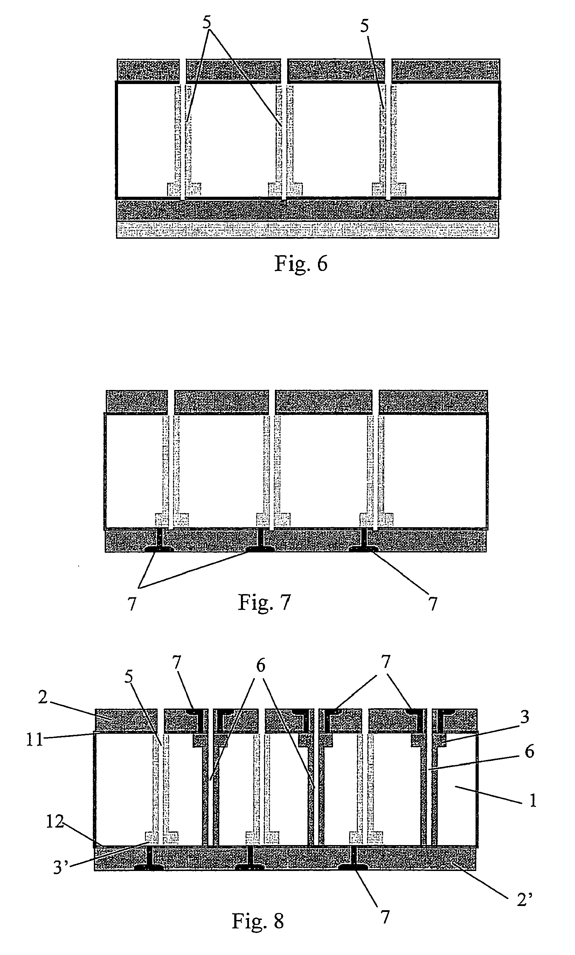

A sensor according to the present invention comprises a wafer 1 whose section comprises two opposite larger sides 11 and 12. On both the larger sides or surfaces of the wafer an oxidation layer 2 and 2' is present. In the wafer volume and near the interface between said second larger side 12 with said second oxidation layer 2', one or more second areolas 3' where the wafer is doped in a second form, for example of type n, see figure 7.

First incisions 5 are made, going through the first oxidation layer 2 from the first side 11 up to said second doped areolas 3' near the interface 12. The lateral surfaces of said first incisions 5 are doped in the same said first form, e.g. of the type n.

First doped areolas 3 are realized near said first side 11 adjacent to said first oxidation layer 2. Such second areolas alternately extend with respect to the said first areolas 3 according to a median longitudinal direction with respect to the wafer.

Second incisions 6 alternate with said first incisions 5 extending through said first oxidation layer 2 from the first side 11 up to the interface between the side 12 and the second oxidation layer 2' and intercepting said first doped areolas 3. The internal surfaces of the wafer being defined by said second doped incisions in a new form, e.g. of the type p and said first areolas being also doped in the same form as said second incision 6. Finally, metallic films 7 are present on both sides 11 and 12 suitable to put into contact said first and second incisions 5 and 6 or said first and second doped areolas 3 and 3'.

On the lateral surfaces defined by said first and second incisions 5 and 6 may be advantageously deposit a thermal oxide.

Moreover, said metallic films may advantageously be passivating.

Advantageously, such a 3D detector allows the simultaneous reading of electric signals on both the larger surfaces, identified by the respective sides 11 and 12 of the sensor's section shown in the figure. Therefore it is possible to make structures on both sides of the slice. This allows, for example, to use particular techniques for reading the detected signals.

During the sensor production process, which will be described below, may be necessary to make a further layer 4 stuck on said second layer 2' of oxide, in correspondence with the side 12 of the wafer.

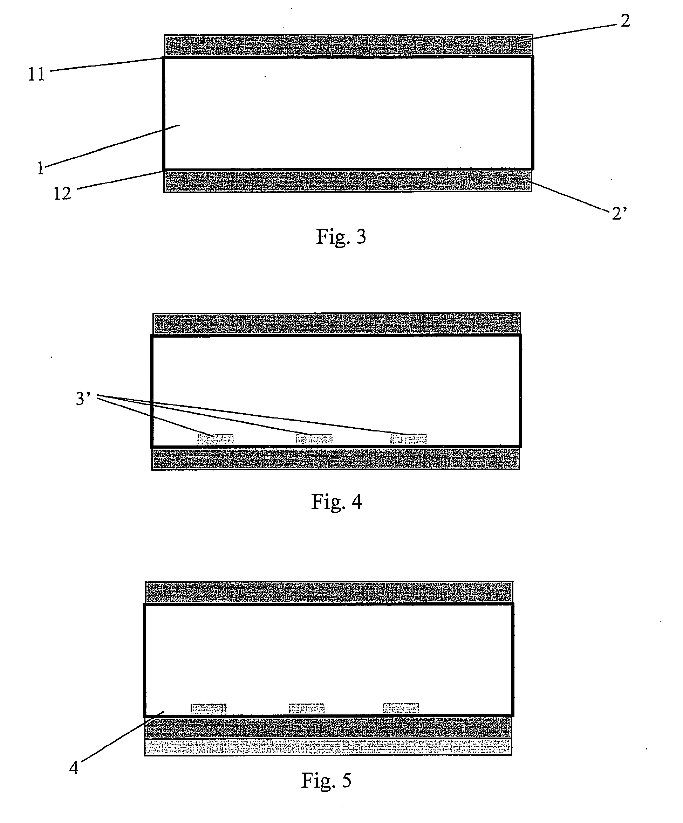

Such further layer 4 may be present in the sensor, if its removal is not included in the manufacturing process of the sensor, as shown in figures 5, 6 and 7.

Figures from 3 to 8 may show a method for the realization of a 3D sensor according to the present invention.

It is worth emphasizing that many of the steps described below may be carried out with a different order, or divided and realized in different moment without departing from the scope of the present invention.

A preferred method for the realization of a 3D solid-state radiation sensor comprises the following steps:
- an oxidation of the slice, producing a first oxidation layer 2 and a second oxidation layer 2' on both the larger sides of the wafer 1;
- a first doping of the interface surfaces 11 and 12 of the wafer with the oxidation layers 2 and 2' obtained in the previous step, suitable for forming an insulation layer;
- a second doping of the interface surfaces 11 and 12 of the wafer suitable for making first areolas 3 and second areolas 3' so that they are conductive and doped in a different way, e.g. the areolas 3 having a doping of type n and the areolas 3' having a doping of type p, moreover the areolas 3 and 3' alternate along a longitudinal section of the wafer parallel to the sheet of the figures, so that a cross section of the wafer passing through an areola 3 does not pass through an areola 3' and vice versa;
- a first etching, preferably DRIE, for the making of first incisions 5 (or second incisions 6), in correspondence of said second areolas 3' (or first areolas 3), so that incisions pass through said oxidation layer 2 in relation to surface 11 up to the interface 12 between the wafer 1 and the second oxidation layer 2'; etching is so that the incision stops on the second oxide layer 2', in order to avoid using a support substrate;
- a first doping of the internal surfaces of the first incisions 5 (or of the second incisions 6) made in the previous step, with the same doping type as said second areolas 3' (or said first areolas 3);
- a possible development or laying down of an oxide covering also the perimetral surfaces defined by said first incisions 5 into the wafer 1;
- a second etching, preferably DRIE, for the making of second incisions 6, in correspondence of said first areolas 3 (or second areolas 3'), so that incisions cross said oxidation layer 2 in relation to surface 11 up to the interface between the wafer 1 and the oxidation layer relating to surface 12; etching is so that the incision stops on the second oxide layer 2', in order to avoid using a support substrate;
- a fourth doping of the internal surfaces of the incisions made in the previous step, with the same doping type as said first areolas 3 (or second areolas 3');
- a possible development or laying down of an oxide covering also the perimetral surfaces defined by said first incisions 6 into the wafer 1 and, if is was not done previously, also of said first incisions 5;
- a removal of parts of the first oxidation layer 2 and of the second oxidation layer 2' and relative underlying portions of insulation of the interfaces 11 and 12 in correspondence, respectively, of said first doped areolas 3 and said second doped areolas 3';
- a laying of metallic film 7 on both sides of the wafer 1 so that it is in contact with said doped areolas 3 and 3';
- a possible removal of the exceeding metal previously placed;
- a possible passivation of the metallic film 7.

The succession of the figures from 3 to 7 shows that it is possible to make first said first incisions and the relative doping of the internal perimetral surfaces of the wafer defined by the incisions themselves, immediately making the metallic contacts 7 and after that making said second incisions, their doping and the metallic contacts.

A layer of multilayer 4 may possibly be attached to the wafer after making the two oxide layers 2 and 2' and the insulation of the interfaces 11 and 12. This layer may be removed later, before making the openings through said oxide layers 2 and 2' which preceding the placing of the metallic films.

Advantageously, the precision in the making of the incision is guaranteed by the usage of a silicon etching of the type DRIE after the making of the oxidation layers, being the latter suitable to stop the DRIE etching just like a multilayer which, however, has to be removed later by means of a laborious mechanical removal. This solution guarantees an accurate precision in making said incisions 5 and 6, so that they always stop on the oxide layer.

Anyway, even though etching a substrate or a support multilayer, after making the oxide layers 2 and 2', it allows an easier removal of the substrate or multilayer. Moreover, by realizing, in addition to the columns, doped cuttings along the sensor borders, this method allows to reduce the dead zones or the detector, namely the zones which do not work, on at least two sides of the sensor itself. The advantages deriving from the present invention are evident, in particular it allows to obtain 3D sensors without any need of sticking a support substrate which has to be removed after the processing. Having an extremely reduced dead area between the sensors allows to interpolate the signals of the non-active regions, without the need of superimposing adjacent detectors, in order to simplify the assembling system.

The elements and the characteristics described in the different preferred embodiments may be combined without departing from the scope of the present invention.

## Claims

1. Method for the production of a 3D solid-state radiation sensor comprising a silicon slice (1) defining, according to its section, two opposites larger sides, the method comprising at least one etching step to the silicon slice for opening incisions (5 or 6) and **characterized in** at least one preliminary step for oxidizing the silicon slice (1), producing at least a first oxidation layer on one of said larger sides, said oxidation layer being suitable to stop said etching of the silicon slice (1).

2. Method according to claim 1, wherein said preliminary step comprises in addition to the production of said first oxidation layer (2) on one of said larger sides (11), also a second oxidation layer (2') on the other of said larger sides (12).

3. Method according to claim 2, comprising a further preliminary step for the making of first doped areolas (3) in the silicon slice (1) near said first oxidation layer (2) and second doped areolas (3') near said second oxidation layer (2'), being said areolas doped in order to be conductive and doped in a different way from each other.

4. Method according to claim 3, wherein said first (3) and second (3') doped areolas alternate along a direction parallel to said opposite larger sides.

5. Method according to the previous claims, wherein said etching step of the silicon slice for opening incisions (5 or 6) is carried out so that the openings are perpendicular to said opposite larger sides in correspondence of said first (3) and second (3') doped areolas.

6. Method according to the previous claims, wherein one of said incisions (5 or 6) is doped in the same way as the intercepting doped areola (3 or 3').

7. Method according to the previous claims, comprising the following steps:
- an oxidization of the silicon slice (1), producing a first oxidation layer (2) and a second oxidation layer (2') on both said larger sides;
- a first doping of a first interface surface (11) and a second interface surface (12) of said larger sides of the slice with, respectively, said first (2) and second (2') oxidation layer, in order to obtain an insulation layer;
- a second doping of said interface surfaces (11 and 12) suitable for making first areolas (3) near said first oxidation layer (2) and second doped areolas (3') near said second oxidation layer (2'), being said areolas doped in order to be conductive and doped in a different way from each other, moreover said first (3) and second (3') areolas alternate in a parallel direction to said opposite larger sides;
- a first etching, preferably DRIE, for making first incisions (5), in correspondence of said second areolas (3') (or first areolas 3), so that the incisions pass through said oxidation layer (2) up to said second interface (12);
- a third doping of the internal surfaces of the first incisions (5) made in the previous step, with the same doping type as said second areolas 3' (or said first areolas 3);
- a second etching, preferably DRIE, for making second incisions (6), in correspondence of said first areolas 3 (or second areolas 3'), so that the incisions pass through said oxidation layer (2) up to said second interface (12);
- a fourth doping of the internal surfaces of the incisions made in the previous step, with the same doping type as said first areolas 3 (or second areolas 3');
- removal of parts of the first oxidation layer (2) and of the second oxidation layer (2') and relative underlying portions of insulation of the interfaces (11 and 12) in correspondence, respectively, of said first doped areolas (3) and said second doped areolas (3');
- laying of metallic film (7) on both sides of the silicon slice (1) so that it is in contact with said doped areolas (3 and 3');

8. Method according to claim 7, further comprising a development or laying down of a thermal oxide covering the perimetral surfaces defined by said first incisions (5) and/or second incisions (6) after the relative third and fourth doping.

9. Method according to the previous claim, comprising a passivating procedure of the metallic films (7) laid down.

10. 3D radiation detector obtained according to one of the previous claims having metallic contacts on two larger sides (11 and 12).
